# EUROPÄISCHE PATENTANMELDUNG

(11) **EP 1 593 979 A2**
(43) Veröffentlichungstag der Anmeldung: **09.11.2005**
(21) Anmeldenummer: 05009533.0
(22) Anmeldetag: 30.04.2005
(51) Int. Cl.: G01R 11/04

(54) **Zählertraggehäuse für einen Zählerschrank**

(30) Priorität: 08.05.2004 DE 102004022783
(71) Anmelder: ABB PATENT GmbH, 68526 Ladenburg (DE)
(72) Erfinder: Michael, Roth, 77886 Lauf (DE); Schaaf, Harry Dipl.-Ing., 77836 Rheinmünster (DE)
(74) Vertreter: Miller, Toivo

(57) **Zusammenfassung**

Die Erfindung betrifft ein Zählertraggehäuse (10) für einen Zählerschrank zur Montage eines Zählers, mit mit Zugangs- und Abgangsleitern (17; 19) verbundenen Kontaktstücken (22, 23; 24), mit denen am Zähler befindliche Kontaktfahnen (37) bei dessen Montage in Eingriff bringbar sind, wobei die Kontaktfahnen (37) durch Schlitze (25, 26, 27, 28, 29, 30) hindurch ins Innere des Gehäuses einfügbar sind und das Gehäuse aus einem Gehäuseunterteil (11), indem die Kontaktstücke (22, 23; 24) gehaltert sind, und einem daran befestigbaren Gehäuseoberteil (12) zusammengesetzt ist. An einem Schenkel (32) der U-förmigen Kontaktstücke (22, 23; 24) sind Anschlussfahnen (35, 40, 43) angeformt, an denen die Zu- oder Abgangsleiter (17, 19) schraubenlos angeschlossen sind.

## Beschreibung

Die Erfindung betrifft ein Zählertraggehäuse gemäß dem Oberbegriff des Anspruches 1.

Aus der DE 10 2004 001 453 ist eine Stromzählereinrichtung bekannt geworden, bei der ein Stromzähler, hier ein elektronischer Haushaltszähler, der mit Kontaktfahnen an seiner Unterseite versehen ist, auf einen Adapter aufgesetzt wird, wobei innerhalb des Adapters Kontaktstücke vorgesehen sind, mit denen die Kontaktfahnen in elektrisch leitende Verbindung bringbar sind. Die Kontaktstücke sind U-förmig ausgebildet und über an einem der Schenkel der U-Form angeschlossene Anschlussfahnen mit Anschlussklemmen verbunden, an denen Zu- bzw. Abgangsleiter angeschlossen werden können.

Das Anschließen dieser Anschlussleiter über diese Anschlussklemme erfordert einen hohen Montageaufwand.

Aufgabe der Erfindung ist es, ein Zählertraggehäuse der eingangs genannten Art zu schaffen, bei dem die Montage vereinfacht ist.

Diese Aufgabe wird erfindungsgemäß durch die Merkmale des Anspruches 1 gelöst.

Erfindungsgemäß also schließt an einem der Schenkel der U-förmigen Kontaktstücke eine Anschlussfahne an, an denen die Zu- oder Abgangsleiter schraubenlos angeschlossen sind.

Gemäß einer ersten Ausführungsform der Erfindung ist am Ende des Zu- oder Abgangsleiters ein Kabelschuh mit einer Anschlusslasche befestigt, welches Anschlusslasche mit der Anschlussfahne unlösbar verbunden ist, diese Verbindung kann durch Verschweißen oder Verlöten erfolgen.

Gemäß einer weiteren Ausführungsform der Erfindung ist an der Anschlussfahne ein Crimpelement angeordnet, mit dem der Leiter mit der Anschlussfahne vercrimpt ist.

Zur Zugentlastung können am Gehäuseunterteil und am Gehäuseoberteil aneinander angepasste, quer zu den Leitungen verlaufende Leisten angeordnet sein, die nach Zusammensetzten des Gehäuseunterteils mit dem Gehäuseoberteil gegen die Außenfläche des Leiters drücken. Zur Unterstützung dieser Zugentlastung kann im Bereich der Einführöffnungen für die Leiter das Gehäuseunterteil mit dem Gehäuseoberteil verschraubt sein, wodurch eine sichere Zugentlastung bewirkt wird.

Bei der Ausführungsform nach der DE 10 2004 001 453 sind die Zug- bzw. Abgangsleiter auf einer Seite des dort beschriebenen Adapters eingeführt; dies kann auch bei dem erfindungsgemäßen Zählertraggehäuse der Fall sein; in besonders vorteilhafter Ausgestaltung allerdings werden die Zugangsleitungen an einer Schmalseite und die Abgangsleitungen an der anderen Schmalseite in das Zählertraggehäuse eingeführt, so dass sowohl auf der Zugangsseite als auch auf der Abgangsseite die Leisten vorgesehen sind, die über die gesamte Breite im Zählertraggehäuse verlaufen, so dass alle Leiter zugentlastet sind.

Anhand der Zeichnung, in der einige Ausführungsbeispiele der Erfindung dargestellt sind, sollen die Erfindung sowie weitere vorteilhafte Ausgestaltungen und Verbesserungen und weitere Vorteile näher erläutert und beschrieben werden.

Es zeigen:
- Fig. 1: eine perspektivische Ansicht auf ein Zählertraggehäuse in geschlossenem Zustand,
- Fig. 2: eine Einsicht ins Innere des Zählertraggehäuses,
- Fig. 3 bis 5: unterschiedliche Anschlussmöglichkeiten eines Zu- oder Abgangsleiters an einem Kontaktstück und
- Fig. 6: eine Teilschnittansicht im Bereich der Einführungsöffnungen eines Zugangs- oder Abgangsleiters.

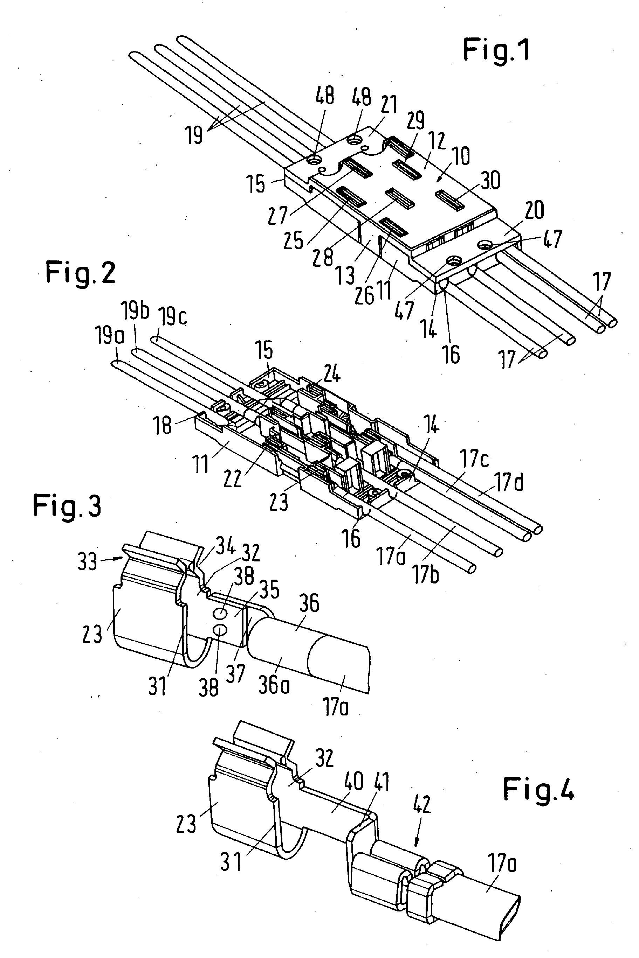

Die Fig. 1 zeigt ein Zählertraggehäuse 10, das in einen Schaltschrank eingebaut werden kann, wie es z. B. in der DE .... (Mp.-Nr 04/555) beschrieben ist. Das Zählertraggehäuse 10 besitzt ein Gehäuseunterteil 11 und ein Gehäuseoberteil 12, an dem Rastarme 13 angeformt sind, mit denen das Gehäuseoberteil 12 am Gehäuseunterteil 11 festgerastet werden kann. Das Zählertraggehäuse 10 ist rechteckig ausgebildet und besitzt auf seinen beiden Schmalseitenwänden 14 und 15, von denen die Schmalseitenwand 15 nicht sichtbar ist, Zugangsöffnungen 16 für Zugangsleiter 17 und Abgangsöffnungen 18 für Abgangsleiter 19. Die Zugangsöffnungen und Abgangsöffnungen 16, 18 sind durch U-förmige Aussparungen an den Schmalseitenwänden 14 bzw. 15 gebildet, die durch das Gehäuseoberteil mit dessen Abschnitten 20 und 21 abgedeckt sind.
Die Zugangsleiter 17a, 17b, 17c und die Abgangsleiter 19a, 19b, 19c sind mit Kontaktstücken verbunden, wobei in der Zeichnung lediglich die dem Zugangsleiter 17a und dem Abgangsleiter 19a zugehörigen Kontaktstücke 22, 23 mit einer Bezugsziffer versehen sind. Die Kontaktstücke für die Zugangs- und Abgangsleiter 17b, 19b sind in gleicher Weise ausgebildet, ebenso wie die Kontaktstücke für die Zu- bzw. Abgangsleiter 17c, 19c der Zugangsleiter 17d ist mit einem Kontaktstück 24 verbunden; der Zugangsleiter 17d ist dann der Neutralleiter.

Den Kontaktstücken 22, 23 sind im Gehäuseoberteil 12 Schlitze 25, 26 zugeordnet, durch die am Zähler angeordnete Kontaktfahnen ins Innere des Zählertraggehäuses 10 eingeführt und mit den zugehörigen Kontaktstücke 22, 23 in Verbindung gebracht werden.

Wie aus der Fig. 1 und der Fig. 2 ersichtlich ist, sind die Schlitze 25, 26,27,28, 29 und 30 - natürlich ebenso wie die zugehörigen und darunter liegenden Kontaktstücke - gegeneinander versetzt, wie dies auch in der oben erwähnten DE .... (Mp.-Nr. 04/555) der Fall ist.

In den Figuren 3 bis 6 sind Kontaktstücke dargestellt, an denen auf unterschiedliche Weise ein Anschlussleiter 17a befestigt ist. Das Kontaktstück trägt die Bezugsziffer 23, wobei die in diesen Figuren gezeigten Kontaktstücke im Bereich ihrer Kontaktierung identisch ausgebildet sind, so dass sie die gleiche Bezugsziffer aufweisen.

Das Kontaktstück 23 ist als U-förmiges Kontaktstück ausgebildet und besitzt zwei Schenkel 31 und 32, an deren freien Enden eine Einkerbung 33, 34 vorgesehen ist, wodurch sich der Abstand der beiden Schenkel in diesem Endbereich zwischen den Einkerbungen 33, 34 verkleinert; eine Kontaktfahne am Zähler greift zwischen die Schenkel und kontaktiert mit den Innenflächen der Einkerbungen 33, 34; diese Innenflächen der Einkerbungen 33, 34 bilden Kontaktflächen.

An dem Schenkel 32 ist eine erste Anschlussfahne 35 angeformt. Das Ende des Leiters 17a ist abisoliert und mit einem Kabelschuh 36 verbunden, der eine zusammendrückbare, zylindrische Aufnahme 36a für das abisolierte Ende des Leiters 17 und eine Kontaktfahne 37 aufweist, die an der Anschlussfahne 35 mit Schweißpunkten 38 befestigt ist.

Bei der Ausführung gemäß Fig. 4 schließt am Schenkel 32 des Kontaktstückes 23 eine hier als zweite Anschlussfahne 40 bezeichnete Anschlussfahne an, die an ihrem freien Ende eine Abwinklung 41 trägt, die senkrecht zur zweiten Anschlussfahne 40 verläuft und hin zum Schenkel 31. An der Abwinklung 41 sind Crimpelemente 42 vorgesehen, zwischen die das abisolierte Ende des Leiters 17a eingeführt wird; danach werden die Crimpelemente durch Verformen in an sich bekannter Weise mit dem Arischlussleiter 17a verquetscht.

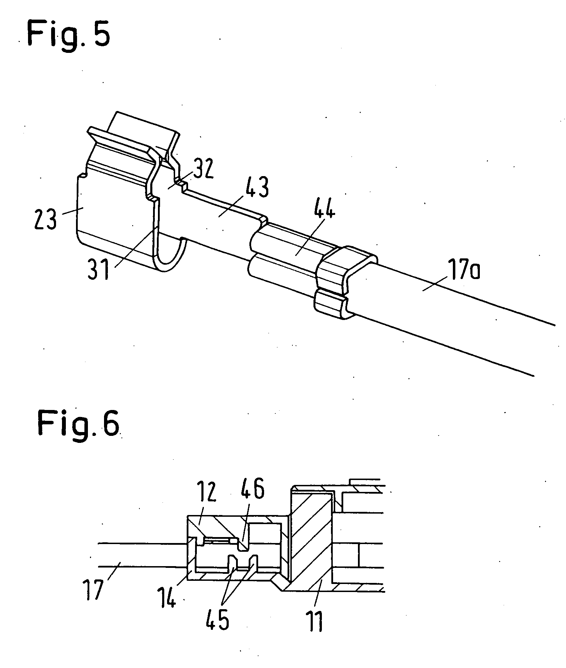

Die Fig. 5 zeigt ein Kontaktstück 23, an dessen Schenkel 32 eine als dritte Anschlussfahne bezeichnete Anschlussfahne 43 angeformt ist, auf deren dem Schenkel 31 zugewandten Fläche den Crimpelementen 42 entsprechende Crimpelemente 44 angeformt ist, zwischen die der Anschlussleiter 17a mit seinem abisolierten Ende gesteckt wird; danach werden die Crimpelemente 44 mit dem Leiter 17a verquetscht. Der Unterschied zwischen der Ausführung nach Fig. 4 und derjenigen nach Fig. 5 besteht lediglich darin, dass die Anschlussfahne 40 die Abwinklung trägt, an deren Außenfläche die Crimpelemente angeformt sind, wogegen die Anschlussfahne 43 ohne Abwinklung ausgebildet ist.

Wie aus Fig. 1 ersichtlich ist, besteht das Gehäuse aus einem,Gehäuseoberteil 12 und einem Gehäuseunterteil 11.

In der Fig. 6, die einen Schnitt parallel zur Verbindungslinie zweier zueinander gehörender Kontaktstücke 22, 23 zeigt, ist dargestellt, dass an der Innenfläche des Gehäuseunterteils 11 im Bereich der Schmalseitenwand 14 zwei senkrecht zur Verbindungslinie zweier zusammengehöriger Kontaktstücke 22, 23 verlaufende Leisten 45 angeformt sind, denen eine Leiste 46 am Gehäuseoberteil 12 entspricht, so dass bei der Verbindung des Gehäuseunterteils 11 mit dem Gehäuseoberteil die Leisten 45, 46 gegen die Außenfläche des Leiters 17 gedrückt werden. Dadurch wird eine Zugentlastung des Leiters 17 und natürlich auch der Leiter 17a bis 17 d bzw. 19a bis 19c erzeugt, welche noch dadurch verstärkt werden kann, dass das Gehäuseoberteil mit dem Gehäuseunterteil im Bereich der Abschnitte 20, 21 mittels Schraubverbindungen 47 gegeneinander verspannt werden.

## Patentansprüche

1. Zählertraggehäuse (10) für einen Zählerschrank zur Montage eines Zählers, mit mit Zugangs- und Abgangsleitern (17; 19) verbundenen Kontaktstücken (22, 23; 24), mit denen am Zähler befindliche Kontaktfahnen (37) bei dessen Montage in Eingriff bringbar sind, wobei die Kontaktfahnen (37) durch Schlitze (25, 26, 27, 28, 29, 30) hindurch ins Innere des Gehäuses einfügbar sind und das Gehäuse aus einem Gehäuseunterteil (11), indem die Kontaktstücke (22, 23; 24) gehaltert sind, und einem daran befestigbaren Gehäuseoberteil (12) zusammengesetzt ist, **dadurch gekennzeichnet, dass** an einem Schenkel (32) der U-förmigen Kontaktstücke (22, 23; 24) Anschlussfahnen (35, 40, 43) angeformt sind, an denen die Zu- oder Abgangsleiter (17, 19) schraubenlos angeschlossen sind.

2. Zählertraggehäuse (10) nach Anspruch 1, **dadurch gekennzeichnet, dass** am Ende jedes Leiters ein Kabelschuh (36) mit Anschlusslasche befestigt ist, die mit der Anschlussfahne (35, 40, 43) am Kontaktstück (23) schraubklemmenlos verbunden ist.

3. Zählertraggehäuse (10) nach Anspruch 2, **dadurch gekennzeichnet, dass** die Anschlusslasche an der Anschlussfahne (35, 40, 43) angeschweißt ist.

4. Zählertraggehäuse (10) nach Anspruch 2, **dadurch gekennzeichnet, dass** die Anschlussfahne (35, 40, 43) mit der Anschlusslasche verlötet ist.

5. Zählertraggehäuse (10) nach Anspruch 1, **dadurch gekennzeichnet, dass** an der Anschlussfahne (35, 40, 43) ein Crimpelement (42, 44) angeformt ist, mit dem der Leiter mit der Anschlussfahne (35, 40, 43) vercrimpt ist.

6. Zählertraggehäuse (10) nach einem der vorherigen Ansprüche, **dadurch gekennzeichnet, dass** an den sich gegenüberliegenden Innenflächen im Bereich der Zu- bzw. Abgangsöffnungen (16 bzw. 18) quer zu den Leitungen verlaufende, aneinander angepasste Leisten (45, 46) angeformt sind, die nach Aufsetzen des Gehäuseoberteils (12) auf das Gehäuseunterteil (11) eine Zugentlastung bewirken.

7. Zählertraggehäuse (10) nach Anspruch 6, **dadurch gekennzeichnet, dass** das Gehäuseunterteil (11) und das Gehäuseoberteil (12) im Bereich der Einführungsöffnungen für die Leiter miteinander verschraubt sind, so dass die Leisten (45, 46) gegen die Außenfläche der Leiter gedrückt sind.
